# EUROPEAN PATENT APPLICATION

(11) **EP 4 592 376 A1**
(43) Date of publication of application: **30.07.2025**
(21) Application number: 24219406.6
(22) Date of filing: 12.12.2024
(51) Int. Cl.: C09K 11/66, H10K 50/115, H10K 85/50

(54) **STABLE PEROVSKITE NANOCRYSTAL FILM**

(30) Priority: 25.01.2024 EP 24154048
(71) Applicant: Ludwig-Maximilians-Universität München, in Vertretung des Freistaates Bayern, 80539 München (DE)
(72) Inventor: URBAN, Alexander, 82061 Neuried (DE); LEO, Ulrich, 80796 München (DE)
(74) Representative: Tautz & Schuhmacher

(57) **Abstract**

The disclosure concerns a method (100) of manufacturing a perovskite nanocrystal (PNC) film (10), comprising providing a substrate (12), applying perovskite nanocrystals (PNCs) (14) to the substrate (12), applying and binding ligand molecules (16) to the perovskite nanocrystals (PNCs) (14), directly crosslinking the ligand molecules (16) to form a perovskite nanocrystal (PNC) film substrate assembly, and separating the perovskite nanocrystal (PNC) film substrate assembly from the substrate to obtain the perovskite nanocrystal (PNC) film (10). The disclosure further concerns a perovskite nanocrystal (PNC) film (10), optionally obtainable by the present method (100), a direct-gap semiconductor (110) comprising the present perovskite nanocrystal (PNC) film (10), and a light-emitting diode (120) comprising the present perovskite nanocrystal (PNC) film (10) or the present direct-gap semiconductor (110), a sensor comprising the present perovskite nanocrystal (PNC) film (10) or the present direct-gap semiconductor (110), and a solar cell (130) comprising the present perovskite nanocrystal (PNC) film (10) or the present direct-gap semiconductor (110).

## Description

The present disclosure relates to the field of solar cells. In particular, the present disclosure discloses a method of manufacturing a perovskite nanocrystal (PNC) film, a perovskite nanocrystal (PNC) film, a direct-gap semiconductor, a light-emitting diode, a sensor, and a solar cell.

Perovskite nanocrystals (PNCs) have emerged as highly promising materials both for solar light harvesting integrated into solar cells or as photocatalysts and for light emission in LEDs or as down converters (A. Kojima, K. Teshima, Y. Shirai, T. Miyasaka, J. Am. Chem. Soc. 2009, 131, 6050; K. Lin, J. Xing, L. N. Quan, F. P. G. de Arquer, X. Gong, J. Lu, L. Xie, W. Zhao, D. Zhang, C. Yan, W. Li, X. Liu, Y. Lu, J. Kirman, E. H. Sargent, Q. Xiong, Z. Wei, Nature 2018, 562, 245; and D. Yang, X. Zhou, R. Yang, Z. Yang, W. Yu, X. Wang, C. Li, S. Liu, R. P. H. Chang, Energy & Environmental Science 2016, 9, 3071, the contents of which are incorporated by way of reference). Particularly, lead and tin halide perovskites have garnered significant attention in recent years as cost-effective and versatile direct-gap semiconductors for LEDs and solar cells.

As a direct semiconductor, Perovskite nanocrystals (PNCs) offer remarkable absorption and emission properties and a potential for near-unity photoluminescence quantum yield (PLQY) (Y. Hassan, Y. Song, R. D. Pensack, A. I. Abdelrahman, Y. Kobayashi, M. A. Winnik, G. D. Scholes, Adv. Mater. 2016, 28, 566; S. T. Ha, X. Liu, Q. Zhang, D. Giovanni, T. C. Sum, Q. Xiong, Adv. Opt. Mater. 2014, DOI: 10.1002/adom.201400106n/a; Q. A. Akkerman, V. D'lnnocenzo, S. Accornero, A. Scarpellini, A. Petrozza, M. Prato, L. Manna, J. Am. Chem. Soc. 2015, 137, 10276; L. Protesescu, S. Yakunin, M. I. Bodnarchuk, F. Krieg, R. Caputo, C. H. Hendon, R. X. Yang, A. Walsh, M. V. Kovalenko, Nano Lett. 2015, 15, 3692; S. De Wolf, J. Holovsky, S.-J. Moon, P. Löper, B. Niesen, M. Ledinsky, F.-J. Haug, J.-H. Yum, C. Ballif, J. Phys. Chem. Lett. 2014, 5, 1035; and Q. A. Akkerman, G. Raino, M. V. Kovalenko, L. Manna, Nat. Mater. 2018, 17, 394, the contents of which are incorporated by way of reference).

Perovskite nanocrystals (PNCs) can find application n perovskite solar cells (PSCs), the functioning of which involves several steps. When sunlight hits the perovskite layer, it absorbs photons and generates excitons. These excitons dissociate into free electrons and holes at the interfaces with other layers of a solar cell, particularly the Electron Transport Layer (ETL) and Hole Transport Layer (HTL). Electrons move towards the ETL and then to the Transparent Conducting Electrode (TCO) of the solar cell, while holes move towards the HTL and then to the back electrode. This movement of electrons and holes creates a current that can be harnessed as electricity. PSCs are highly efficient, with power conversion efficiencies of over 25%, and offer the potential for low-cost production using solution-based processes.

However, challenges remain, such as the long-term stability, particularly the mechanical stability, of the perovskite films, which makes them difficult to handle and affects their lifetime. For instance, it is known that perovskite films produced by dry transfer printing suffer from internal cracking of the thin film during the transfer process (Jong Ik Kwon, Gyuri Park, Gwang Heon Lee, Jae Hong Jang, Nak Jun Sung, Seo Young Kim, Jisu Yoo, Kyunghoon Lee, Hyeonjong Ma, Minji Karl, Tae Joo Shin, Myoung Hoon Song, Jiwoong Yang, and Moon Kee Choi, Science Advances 2022, 8, 43).

For increasing the stability of perovskite films Meng Li, Ying-Guo Yang, Zhao-Kui Wang, Tin Kang, Qiong Wang, Silver-Hamill Turren-Cruz, Xing-Yu Gao, Chain-Shu Hsu, Liang-Sheng Liao, Antonio Abate, Adv. Mater. 2019, 31, 25 use photo-crosslinked [6,6]-phenylC₆₁-butyric oxetane dendron ester (C-PCBOD) to improve the mechanical stability of methylammonium lead iodide (MAPbI₃) perovskite films. The C-PCBOD passivates the grain boundaries, which reduces the formation of trap states and enhances the environmental stability of MAPbI₃.

The methods of the prior art have the drawback that the perovskite nanocrystal films only stabilize the boundaries of the perovskite films. Further drawbacks reside in that the prior art method yields perovskite nanocrystal films of inconsistent quality and with a limited lifetime.

The present disclosure seeks to overcome the above drawbacks. One objective of the present disclosure is to provide a perovskite nanocrystal film that can be reliably produced with large dimensions and sufficient mechanical stability to make it suitable for technical and/or industrial applications, such as solar cell production. Another objective is to provide a perovskite nanocrystal film with consistent quality and/or sufficient lifetime for various applications such as solar cell manufacturing. A further objective is to provide a perovskite nanocrystal film that can be easily handled and subjected to additional processing steps without the need for special precautions. A further objective is to provide a method of producing such a perovskite nanocrystal film.

It is therefore desirable to provide a solution by means of which a perovskite nanocrystal film may be produced, wherein the film has large dimensions and fulfils the demands of efficient direct-gap semiconductors such that it may be used in light-emitting diodes or solar cells. Another objective resides in the provision of a method of producing a perovskite nanocrystal film with high stability against environmental influences, such as mechanical stress, and solvents, with consistent quality, and/or long lifetime. Still another objective resides in the provision of a method of producing a perovskite nanocrystal film, wherein at least one outer surface, preferably the entire surface, is protected against environmental influences, whilst the interior of the film is chemically non affected, thus, functions in a conventional manner.

This is solved by the objects of the independent claims. Advantageous embodiments are indicated in the dependent claims and in the description.

In a first aspect, the invention concerns a method of manufacturing a perovskite nanocrystal (PNC) film. The method comprises providing a substrate, applying perovskite nanocrystals (PNCs) to the substrate, applying and binding ligand molecules to the perovskite nanocrystals (PNCs), directly crosslinking the ligand molecules to form a perovskite nanocrystal (PNC) film substrate assembly, and separating the perovskite nanocrystal (PNC) film substrate assembly from the substrate to obtain the perovskite nanocrystal (PNC) film.

The contents of EP 24 154 048 are incorporated herein by reference in their entirety for all purposes. In particular, the method may be performed according to the disclosure of this European patent application.

In a further aspect, the invention concerns a Perovskite nanocrystal (PNC) film obtainable by the present method.

In still a further aspect, the invention concerns a perovskite nanocrystal (PNC) film. The perovskite nanocrystal (PNC) film comprises, preferably consists of, perovskite nanocrystals (PNCs), and ligand molecules binding the perovskite nanocrystals (PNCs), wherein the ligand molecules are directly crosslinked, optionally further comprising a substrate supporting the perovskite nanocrystal (PNC) film.

In still a further aspect, the invention concerns a direct-gap semiconductor comprising the present Perovskite nanocrystal (PNC) film.

In another aspect, the invention concerns a light-emitting diode comprising the present perovskite nanocrystal (PNC) film or the present direct-gap semiconductor, a sensor comprising the present perovskite nanocrystal (PNC) film or the present direct-gap semiconductor, or a solar cell, particularly a tandem solar cell, comprising the present perovskite nanocrystal (PNC) film or the present direct-gap semiconductor.

A perovskite nanocrystal (PNC) is a material particle that usually has at least one dimension of 2 nm to 50 µm, 3 nm to 10 µm, 4 nm to 1 µm, 5 nm to 500 nm, 6 nm to 100 nm, 7 nm to 50 nm, 8 nm to 40 nm, 9 nm to 30 nm, 10 nm to 25 nm, or 15 nm to 20 nm. Preferably the perovskite nanocrystal (PNC) is a monodisperse perovskite nanocrystal (PNC) having a cubic or distorted cubic morphology, such as orthorhombic or tetragonal, and uniform edge length of 2 nm to 50 µm, such as 3 nm to 10 µm, 4 nm to 1 µm, 5 nm to 500 nm, 6 nm to 100 nm, 7 nm to 50 nm, 8 nm to 40 nm, 9 nm to 30 nm, 10 nm to 25 nm, or 15 nm to 20 nm. A uniform edge length with respect to a cubic or distorted cubic morphology means that, with respect to a longest edge length, all other edge lengths are not more than 10%, preferably not more than 5% or 1%, shorter than the longest edge length. The perovskite nanocrystal (PNC) can be based on quantum dots and is usually composed of atoms in a single-crystalline arrangement, though polycrystalline forms can also occur. Exemplary perovskite nanocrystals also include nanorods and/or nanoplatelets.

A perovskite may have the general formula ABX₃, wherein A and B are each atoms with a positive charge, and X atoms with a negative charge, such as an halide and/or oxygen. A, B, and X may be further independently from each other composed of different atoms of the same valency. Perovskite nanocrystals (PNCs) often comprise ABClₓBr_{y}I_{z} with A = a first organic ligand, Rb and/or Cs, B = a second organic ligand, Cu, Pb and/or Sn, 0 ≤ x ≤ 3, 0 ≤ y ≤ 3, and 0 ≤ z ≤ 3 with the proviso that x + y + z = 3 and that at least one of A and B comprises a metal atom. Exemplary and preferred perovskite nanocrystals (PNC) include Methylammonium Lead Iodide (MAPbI₃), Formamidinium Lead Iodide (FAPbI₃, Cesium Lead Iodide (CsPbI₃), Mixed Halide Perovskites, such as Methylammonium Lead Iodide-Bromide (MAPbI₃₋ₓBrₓ), Triple-Cation Perovskites, Tin-based Perovskites, such as Methylammonium Tin Iodide (MASnI₃), Mixed Cation and Mixed Anion Perovskites, an 2D Perovskites, such as (C4H₉NH₃)₂PbI₄. Examples of preferred perovskite nanocrystals (PNCs) comprise APbX₃ perovskite nanocrystals, wherein A is selected from the group consisting of methylammonium, cesium, formamidinium, and X is selected from F, Cl, Br, I. Preferably X is selected from Br and I, more preferably X is I. Another example of preferred perovskite nanocrystals (PNC) comprises CsPbBr₃ perovskite nanocrystals.

Because of the high surface-to-volume ratio, the optical and optoelectronic performance, and the colloidal stability of Perovskite nanocrystals (PNCs) may depend on their surface chemistry, especially the ligands and surface termination. On the one hand, the ligands may improve the colloidal stability and luminescence; on the other hand, the highly dynamic binding nature of ligands may be detrimental to the colloidal stability and photoluminescence of the perovskite nanocrystals (PNCs). In addition, a surface functionalization with desired molecules may introduce new functionalities such as chirality, light harvesting, and triplet sensitization through energy/electron transfer or use as X-ray detectors.

The size of nanoparticles, particularly perovskite nanocrystals (PNCs), can be provided by D₅₀ values. D₅₀ is a corresponding particle size when a cumulative volume percentage of the active material reaches 50%, that is, a median particle size in volume distribution. D₅₀ may be measured by using a laser diffraction particle size distribution measuring instrument, preferably a Malvern Mastersizer 3000, usually according to the manufacturer's instructions.

A layer thickness of e.g. a perovskite nanocrystal film may be measured using a stylus thickness gauge (Millitron 1202 D, manufactured by Mahr), usually according to the manufacturer's instructions. Optionally, the thickness of a PNC film may be adjusted calculated from the amount of Perovskite nanocrystals (PNCs) to be deposited on a surface area of known dimensions. It can be assumed that the ligands and their crosslinking of the ligands does not have an impact on the thickness, such that the thickness of the PNC film can be determined on the basis of the Perovskite nanocrystals alone.

Optionally, if the preparation of the perovskite nanocrystal film layer is carried out by spin coating, the thickness can be determined by using the amounts, i.e. weight, of the educts, preferably only the educts forming the Perovskite nanocrystals (PNCs) used to form the perovskite nanocrystal film and the surface dimensions of the substrate to be coated. This facilitates determining the layer thickness.

The thickness of a perovskite nanocrystal film layer can also be expressed, if not measured, in a first approximation as the number of crystal layers on top of each other, considering only the constituents of the above general formula ABX₃ and assuming that the perovskite nanocrystals have a uniform edge length, i.e. cubic morphology.

The perovskite nanocrystal (PNC) film is an essentially flat structure with a relatively large upper and lower surface and edges that connect the upper and lower surfaces. As used herein, the upper and lower surface can be referred to as side surfaces or sides and the lower surface is usually adjacent to a substrate, or a release layer of the substrate, if present.

The present perovskite nanocrystal (PNC) film produced by the claimed method, without repeating any or all of (i) applying perovskite nanocrystals (PNCs) to the substrate, (ii) applying and binding ligand molecules to the perovskite nanocrystals (PNCs), and (iii) directly crosslinking the ligand molecules, generally can have dimensions of about ≤ 1.000 nm, such as about ≤ 100 nm, particularly in the longest dimension. Specifically, the perovskite nanocrystal (PNC) film may have a substantially rectangular or square (upper) surface area and/or a substantially rectangular or square base area with a width and length independently selected from about 5 nm to about 1.000 nm, such as 6 nm to 750 nm, 7 nm to 500 nm, 8 nm to 250 nm, 9 nm to 100 nm, 10 nm to 90 nm, 12 nm to 80 nm, 14 nm to 90 nm, 16 nm to 80 nm, 18 nm to 60 nm, 20 nm to 50 nm, or 30 nm to 40 nm. The thickness of the present perovskite nanocrystal (PNC) film produced by the method of claim 1 without repeating the step of depositing perovskite nanocrystals (PNCs) on the substrate is in the range of about 0.8 nm to about 5.0 nm, such as 0.8 nm to 5.0 nm, 1.0 nm to 3.0 nm, preferably 1.2 nm to 1.4 nm, 1.25 to 1.35 nm, or 1.75 nm to 1.30 nm.

The thickness of a present perovskite nanocrystal (PNC) film produced by the method according to claim 1, wherein the steps of (i) applying perovskite nanocrystals (PNCs) to the substrate, (ii) applying and binding ligand molecules to the perovskite nanocrystals (PNCs), and (iii) directly crosslinking the ligand molecules are optionally repeated, such as 1 times or more, 2 - 100 times, 3 - 50 times, 4 - 25 times, or 5 to 10 times, is not particularly limited. The thickness of such films may be in range of about 2 nm to about 500 µm, 3 nm to 100 µm, 4 nm to 10 nm, 5 nm to 1 µm, 6 nm to 500 nm, 7 nm to 200 nm, 8 nm to 100 nm, 9 nm to 90 nm, 10 nm to 80 nm, 12 nm to 70nm, 14 nm to 60 nm, 16 nm to 50 nm, 18 nm to 40 nm, or 20 nm to 30 nm.

The present perovskite nanocrystal (PNC) films can be quantum-confined. Quantum-confined perovskite films generally refer to perovskite materials whose properties are influenced by quantum confinement effects, typically due to their reduced dimensionality, such as in nanocrystals or quantum dots. In these systems, the perovskite structure is modified at the nanoscale, leading to changes in electronic and optical properties. Quantum confinement occurs when the size of the material is reduced to the scale of the exciton Bohr radius (on the order of nanometers), creating discrete energy levels and altering the optical absorption, emission, and electronic transport properties of the material. This can alter properties such as photoluminescence, carrier mobility, and stability compared to bulk perovskites. For the present perovskite nanocrystal (PNC) films, quantum confinement can occur when a blue shift in the absorption and/or photoluminescence spectra is detectable. Optionally the blue shift in the absorption and/or photoluminescence spectra is at least 20 nm, such as at least 25 nm, or at least 30 nm. The excitation wavelength depends essentially on the size of the nanocrystals in the perovskite nanocrystal film. For instance, for CsPbBr₃ perovskite nanocrystals having a bandgap around 2.3 eV or 540 nm, a typical excitation wavelength is about 300 nm to about 450 nm. For MAPbI₃ perovskite nanocrystals having a bandgap around 1.5 eV or 820 nm, a typical excitation wavelength is about 300 nm to about 600 nm.

Qualitative and quantitative measurements for a blue shift for determining quantum-confinement can be performed at environmental conditions, i.e. room temperature of about 21 °C to about 24 °C, or 22 °C to 23 °C, and optionally at ambient pressure of about 965 hPa to about 1060 hPa, such as 1000 hPa to 1020 hPa, or 1013.25 hPa. An exemplary device for quantitative measurement is a Genesys 150 UV/VIS-spectrophotometer by ThermoFisher that can be used according to the manufacturer's instructions. A preferred device for qualitative and/or quantitative measurement for a blue shift for determining quantum-confinement is the FluoroMax Plus by HORIBA Scientific that can be used according to the manufacturer's instructions.

A ligand molecule is an organic molecule, which coordinates to a metal ion via a dative bond (coordinative bond). The functional group affording the coordinative bond is denoted first functional group. The ligand molecule may have a plurality of first functional groups, such as two or more, three to ten, or four to five first functional groups. A single ligand molecule having such a plurality of first functional groups, or a dentate ligand molecule, may afford directly crosslinking of the perovskite nanocrystals by enabling ligand bonding between two or more perovskite nanocrystals. In addition, the ligand molecule may have one or more second functional groups that can afford another type of direct crosslinking, optionally by forming covalent bonds.

The present ligand molecules are therefore capable of direct crosslinking two or more perovskite nanocrystals by a first functional groups that binds directly to a perovskite nanocrystal and/or a second functional group binding to a second functional group of another ligand molecule. Direct crosslinking may take place by mixing the constituents, such as dentate ligand molecules and perovskite nanocrystals (PNCs), or may require the presence of e.g. a catalyst for forming a bond, such as a covalent bond, between second functional groups. Directly crosslinking thus involves a polymerization reaction without any auxiliary compound which affords interconnection of the ligand molecules. This contrasts with indirect crosslinking involving the use of auxiliary compounds, which forming part of the polymerization product but are not directly linked to a perovskite nanocrystal (PNC). It has been found that these auxiliary compounds can complicate the polymerization reaction and/or can impede the function of the perovskite nanocrystal film.

The ligand molecules are not particularly limited and different types of ligand molecules may be employed for forming the PNC film and/or additional PNC layers of on the PNC film for increasing its thickness. Preferred ligand molecules have at least one, preferably a single, CC double bond and at least one, preferably a single, terminal functional group different from a CC double bond, wherein the terminal function group is capable of coordinating to a metal atom of a PNC. Non-limiting examples of such terminal functional groups include hydroxyl, thiol, carboxyl, amide, primary amine, secondary amine, and tertiary amine. It is particularly preferred that direct crosslinking of the ligand molecules includes radiation, preferably collimated radiation. Collimated ration has the advantages that a large surface area can be subjected to essentially the same direct crosslinking conditions, which can add to the mechanical stability of the PNC film, and that direct crosslinking can be also performed through the substrate and the optional release layer, i.e. on both sides, provided that the substrate and optional release layer are made of suitable materials.

The substrate is not particularly limited. Examples of substrate material include a glass material, a silicon material, or a polymeric material, which materials can be transparent to radiation, such as UV light radiation, used for direct crosslinking. The substrate can have an essentially flat surface, which can facilitate spin-coating, or any other shape such as a hypersurface. A flat substrate is preferred.

Examples of preferred ligand molecules comprise styrene and 2-vinylpyridine suitable for the synthesis of polystyrene-r-poly(2-vinylpyridine), wherein r is a bond, i.e. as in polystyrene-b-poly(2-vinylpyridine), or an optional copolymer, such as a molecule with a CC double bond, preferably a terminal CC double bond. Polystyrene-b-poly(2-vinylpyridine) is preferred. A polystyrene-b-poly(2-vinylpyridine) can be synthesized e.g. by living anionic polymerization or by radiation, such as UV light radiation, the synthesis is well known in the art. Other examples of preferred ligand molecules comprise an alkyl carboxylic acid, an alkyl amine, and/or an alkyl alcohol, wherein at least one of the alkyl carboxylic acid, alkyl amine, and alkyl alcohol is unsaturated, such as oleic acid and/or oleylamine. It is particularly preferred that direct crosslinking of these ligand molecules includes radiation, preferably collimated radiation.

Optionally, the number of different ligand molecules is limited. Preferably, not more than one or two different ligand molecules are used. More preferably each of the different ligand molecules has a low molecular weight, which can be lower than 500 g/mol, such 100 to 400 g/mol, or 200 g/mol to 300 g/mol. The small number of different ligand molecules and/or their low molecular weight, i.e. reducing potentially interfering influences of the ligand molecules, can contribute to the proper functioning of the PNC film.

The term catalyst usually implies that it is essentially not consumed while catalyzing a reaction. Thus, the catalyst may be present in the perovskite nanocrystal film, e.g. trapped between crystals, and/or attached to a ligand molecule, depending on the nature of the catalyst, i.e. if the ligand molecule is capable of binding to a metal atom of a catalyst, if such a metal atom is present. As a result, the catalyst can be detected in the perovskite nanocrystal film. In addition, the catalyst can be used in relatively small quantities, so that after polymerization, reminders of intact catalyst and/or its decomposition products has little or no effect on the performance of the PNC film.

The disclosure offers the advantage that the present perovskite nanocrystal film exhibits a high stability, particularly mechanical stability and/or chemical stability, particularly against hydrolysis, and thus may be easily handled, including e.g. dry transfer, such as a dry stamp transfer, or wet transfer, even without using a solid support, without suffering substantial damage. The increased stability, particularly mechanical stability and/or chemical stability, particularly against hydrolysis, furthermore facilitates manufacturing of the present perovskite nanocrystal film, and lowers its production costs. A further advantage is that also stability, particularly mechanical stability and/or chemical stability, particularly against hydrolysis, of products manufactured from the present perovskite nanocrystal film, e.g. a direct gap semiconductor, a light emitting diode, or a solar cell, is increased. Without wishing to be bound by any theory it is furthermore expected that the present direct crosslinking approach, i.e. crosslinking of the ligand molecules as such, without auxiliary constituent forming part in the polymerization product, assists in improving the efficiency of the present the present perovskite nanocrystal film, and the product derived therefrom, e.g. g. a direct-gap semiconductor, a light-emitting diode, a sensor, or a solar cell, as the polymerization product is essentially formed between individual perovskite nanocrystals but not on the surface of the perovskite nanocrystal film. In addition, forming of bulky polymerization products is prevented, which in themselves may affect light absorption of the present perovskite nanocrystal film. Another advantage can be that any type of direct crosslinking method can be used. Depending on the direct crosslinking method and the type of the substrate, it is even possible to stabilize, particularly mechanically stabilize and/or chemically stabilize, particularly against hydrolysis, the perovskite nanocrystal film from two sides. Particularly by building up the perovskite nanocrystal film by adding up to five layers, preferably one or two layers on at least one of the sides of a perovskite nanocrystal film, using the present approach, enables building up thick perovskite nanocrystal films of high stability, as essentially each single perovskite nanocrystal is crosslinked to adjacent perovskite nanocrystals. As noted above, the layers of a perovskite nanocrystal film refer to the number of crystal layers on top of each other, without considering ligands or other atoms or molecules that may be present in the structure. This is in contrast with known approaches offering only polymerized ligand networks over the surface of a perovskite nanocrystal film without stabilizing deeper layers.

The present perovskite nanocrystal film may be furthermore handled as such, without the need of adhering, the side surface area, the entire base area and/or the entire (upper) surface area to any other surface, such as a substrate. For instance, less than 50%, such as less than 10%, less than 1%, less than 0.1 %, or even 0%, e.g. in form of a free floating film, of the film's side surface area, the entire base area and/or the entire (upper) surface area may be attached to any other surface, such as a substrate. For example, the present perovskite nanocrystal film can be stretched over another object, such as portions of the side surfaces of the film that have been chemically modified, e.g., by a ligand that allows binding to another entity arranged in such a way that the film can be stretched over the another object.

Optionally, the order of the steps of applying perovskite nanocrystals (PNCs) to the substrate and applying and binding ligand molecules to the perovskite nanocrystals (PNCs) are exchanged and applying and binding ligand molecules to perovskite nanocrystals (PNCs) is performed before applying the perovskite nanocrystals (PNCs) to the substrate. Optionally, applying perovskite nanocrystals (PNCs) to the substrate and applying and binding ligand molecules to the perovskite nanocrystals (PNCs) are performed simultaneously. Perovskite nanocrystals (PNCs) and ligand molecules can be applied to the substrate under conditions allowing the binding of the ligand molecules to the perovskite nanocrystals. These conditions are known to the skilled person and can involve spontaneous chemical reactions taking place under environmental conditions. Binding of the ligand molecules to the perovskite nanocrystals can occur via a first functional group of the ligand molecules.

Directly crosslinking the ligand molecules to form a perovskite nanocrystal (PNC) film substrate assembly can involve either attaching a second functional group of a first ligand molecule, which is attached via a first functional group to a first perovskite nanocrystal, to a second perovskite nanocrystal, or attaching a second functional group of a first ligand molecule, which is attached via a first functional group to a first perovskite nanocrystal, to a second functional group of a second ligand molecule, which is attached via its first functional group to a second perovskite nanocrystal. Attaching can involve forming a chemical (covalent) bond and/or forming an ionic/ligand binding. In case of directly crosslinking the first and second perovskite nanocrystals by a single, the first, ligand molecule, it is preferred that the first and second functional groups either both allow forming chemical (covalent) bond or an ionic/ligand bond, preferably an ionic/ligand bond. The latter case, in which the first and second functional group allow forming ionic/ligand bonds, the first and second functional groups may be the same or different. In case of directly crosslinking the first and second perovskite nanocrystals by two, the first and the second, ligand molecules, it is preferred that the first functional group allows forming an ionic/ligand bond and the second functional group a chemical (covalent) bond. It will be appreciated that the first and second ligand molecules may also sandwich one or more, such as two or three, other molecules by having functional groups attached to the second functional groups of the first and second ligands, respectively.

Optionally, the steps of applying perovskite nanocrystals (PNCs) to the substrate, applying and binding ligand molecules to the perovskite nanocrystals (PNCs), and directly crosslinking the ligand molecules to form a perovskite nanocrystal (PNC) film substrate assembly are all performed simultaneously. This can occur if the ligand molecule is a multidentate ligand, i.e. a ligand having first and second functional groups or a plurality of first functional groups, which allow simultaneous binding of the ligand to the first and second perovskite nanocrystals, and possibly one or more additional perovskite nanocrystals.

Optionally applying perovskite nanocrystals (PNCs) to the substrate and/or applying and binding ligand molecules to the perovskite nanocrystals (PNCs) includes spin-coating. Spin-coating is a technique well known in the art and can facilitate the production of thin films with consistent and predefined thickness. Spin-coating may be a procedure that may be used to deposit uniform thin films onto flat substrates. Usually, a small amount of coating material is applied on the center of the substrate, which is either spinning at low speed or not spinning at all. The substrate is then rotated at speeds up to about 10,000 rpm, such as about 5,000 rpm to about 8,000 rpm, to spread the coating material by centrifugal force. Alternatively, dropcasting can be employed, which can involve pouring a solution onto the substrate in the form of drops and allowing the drops to dry without spreading; when the drops are projected onto the substrate, the liquid initially spreads from the drop sites across the surface due to the interfacial forces which tend to drive the droplet outwards. As multiple droplets were projected onto the substrate surface, when the edges of the droplets come into contact with each other, they mix to form a non-circular drop with an essentially concave contact line. Spin-coating can involve that the steps applying perovskite nanocrystals (PNCs) to the substrate, applying and binding ligand molecules to the perovskite nanocrystals (PNCs) are performed at the same time. Other well-known techniques for applying the perovskite nanocrystals and/or applying and binding ligand molecules to the perovskite nanocrystals (PNCs) may be used as well, including blade coating, slot-die coating, spray coating, vacuum deposition/thermal evaporation, chemical vapor deposition (CVD), thermal annealing, hot casting, solvent engineering, and sequential deposition. Spin-coating is preferred.

Optionally each of the ligand molecules has at least one first functional group adapted to bind to the perovskite nanocrystals (PNC) and optionally at least one second functional group adapted to directly crosslink with at least one functional group of another ligand molecule. As noted above the at least one first functional group provides the "ligand function" of the ligand molecule by forming an ionic bond to the perovskite nanocrystal and the at least one second functional group offering polymerization, usually in presence of a catalyst, by directly interconnecting the second functional groups, usually two second functional groups.

Optionally, the direct crosslinking the ligand molecules comprises one or more of radiation induced polymerization, such as electron radiation induced polymerization, X-ray radiation induced polymerization, UV light radiation induced polymerization or thermal radiation induced polymerization, chemically induced polymerization, and ligand bonding, preferably wherein the direct crosslinking the ligand molecules includes applying a catalyst. The above polymerization methods are well known in the art. The skilled person is well aware about their use, including the catalyst, solvents, etc.

Radiation induced polymerization is preferably performed using collimated radiation, which has been generally found resulting in a more uniform crosslinking of the entire surface of the PNC film with a higher (mechanical) stability. In addition, it offers the possibility to synthesize the PNC film on a radiation permissive substrate, such that both sides of the PNC film and optionally also the edges may be readily subjected to crosslinking. Examples of preferred collimated radiation include a collimated electron beam and collimated UV light radiation, such as collimated UV light radiation at a wavelength of 254 nm.

Optionally, the direct crosslinking of the ligand molecules comprises radiation induced polymerization, wherein the substrate is at least partially permissive to the radiation, and the direct crosslinking of the ligand molecules includes transmitting the radiation through the substrate. Examples of substrates that are at least partially permissive to the radiation include glasses of different types and polymers. For instance, quartz glass may be used for a UV light radiation induced polymerization of the ligand molecules, particularly the at least one second functional groups.

Optionally, the substrate includes a release layer adapted to separate the substrate from the perovskite nanocrystal film. A preferred example is a release layer made of polymethylmethacrylate. PMMA, which can be essentially completely dissolved in some organic solvents, particularly acetone or n-hexane, without affecting the perovskite nanocrystal film. Another preferred example is a release layer made of polyethylenglycole, such as PEG 2000 (Sigma Aldrich), which can be essentially completely dissolved in water. Still another preferred example, is a release layer made of AZ 125 NXT Photoresist (MicroChemicals GmbH, Germany), which employed according to the manufacturer's instructions. The release layer can have any thickness, such as a thickness of about 0.1 µm to 100 µm, such as 1 µm to 50 µm, or 10 µm to 20 µm. A release layer of a desired thickness may be easily produced by spin-coating, such as dropcasting. The release layer can permit stripping off the Perovskite nanocrystal (PNC) film from the substrate. This has the advantage that ready to use Perovskite nanocrystal (PNC) films for e.g. a direct-gap semiconductor, a light-emitting diode, a sensor, and/or a solar cell may be easily prepared. A preferred example of a substrate is a silicon substrate.

Optionally, the method further comprises, after directly crosslinking the ligand molecules and/or after separating the perovskite nanocrystal (PNC) film from the substrate, applying perovskite nanocrystals (PNCs) to the perovskite nanocrystal (PNC) film, applying and binding ligand molecules to the perovskite nanocrystals (PNCs), directly crosslinking the ligand molecules (16) to obtain the perovskite nanocrystal (PNC) film with higher film thickness. This step or these steps can be repeated several times, such as two times or more, such as 3 to 50 times, or 5 to 10 times. Hence, one or both sides of the perovskite nanocrystal (PNC) film may be thickened by adding one or more layers of perovskite nanocrystals. The perovskite nanocrystals (PNCs) forming these additional layers are again interconnected and connected to the already existing perovskite nanocrystal (PNC) film by ligand molecules. Thereby, the overall thickness of perovskite nanocrystal (PNC) film may be easily adjusted. In addition, it may be assumed that its stability, particularly mechanical stability, is further increased since the added layers can be extensively crosslinked. The addition of these additional layers affects the chemical composition the perovskite nanocrystal (PNC) film and can even at least partially inhibit ionic transfer through the layers.

Optionally, applying perovskite nanocrystals (PNCs) to the substrate and applying and binding ligand molecules to the perovskite nanocrystals (PNCs) are carried out simultaneously. This further reduces complexity of the method. For instance, A multidentate ligand, i.e. ligand bearing two or more first functional groups, may be employed,

Optionally, the PNC film comprises at least 50 wt.%, optionally at least 75 wt.%, perovskite nanocrystals (PNCs). The high content of perovskite nanocrystals (PNCs) usually increases efficacy of the PNC film.

Optionally, the perovskite nanocrystals (PNCs) are monodisperse perovskite nanocrystals (PNCs). This can ensure an equal layer thickness of the PNC film and can further assist in achieving a good efficacy.

Optionally, the film is a thin film, optionally of a thickness of about one to five, such as two, nanocrystals (PNCs). This ensures that the catalyst, particularly a catalyst affecting radiation induced polymerization, can reach not only the surface layer but also deeper layers, such that the perovskite nanocrystals may be properly interconnected by the ligand molecules.

Optionally, the alkyl carboxylic acid, the alkyl amine, and the alkyl alcohol comprise independently from each other 12 to 22 C-atoms, preferably wherein the alkyl amine comprises, or essentially consists of, oleylamine and/or the unsaturated alkyl carboxylic acid

Optionally, the Perovskite nanocrystal (PNC) film is resistant to washing with polar solvents and apolar solvents, wherein the polar solvents include solvents with a polarity that is lower than the polarity of water and the apolar solvents include solvents with a polarity that is higher than the polarity of n-hexane. This has the advantage that the present film may be easily washed, purified, and/or released/ stripped off from a substrate and/or transferred to another substrate. Exemplary substrates include a silicon wafer that is optionally coated.

Optionally, a method of manufacturing a perovskite nanocrystal (PNC) film is provided. The perovskite nanocrystal (PNC) film has sufficient stability for a dry or wet transfer. Crosslinking of ligand molecules serves both as a stabilizer against the solvent during the dry or wet transfer and to increase the mechanical stability by having a direct connection between perovskite NCs via a connected ligand pair. The first step is coating the substrate with any material, the release layer, that is easily dissolvable with acetone but not hexane and leaving a thick film. The film is preferably smooth, making spin-coating optimal. PMMA or AZ 125 NXT Photoresist (MicroChemicals GmbH, Germany) as material for the release layer is applied with low rotation speeds to a silicon substrate to obtain a thick film. To dry the thick film, a long spin-coat time followed by drying on a hotplate according to manufacturer instructions. The release layer may be for dissolving after dry or wet transfer and reduces the forces acting on the perovskite nanocrystal (PNC) film. A thin film of PNCs (of a thickness of about 15 nm to about 20 nm) is spin coated on top of the release layer with a rotation speed of 4000 rpm. The thickness of the thin film has been proven thin enough to be fully penetrated and crosslinked via radiation with a collimated electron beam. Aa dose of about 4mC/cm² is chosen to ensure stability to the acetone bath. In the resulting second network of ligand molecules, the ligand molecules comprise first functional groups for binding the ligand molecules to the PNCs, the first functional groups preferably allowing ionic binding to the PNCs e.g. by an amino or hydroxyl group, and a second functional group for interconnecting/ crosslinking the ligand molecules with each other, e.g. by subjecting a first network comprising PNCs and ligand molecules, wherein the second functional groups are not interlinked/ crosslinked, to radiation, such as the collimated electron beam, or any other means affecting the reaction of the second functional groups, such as a catalyst. The obtained second network is mechanically stabilized and can be subjected to further spin coating steps without affecting, e.g. disrupting, the second network. Via a slower rotation speed with the standard of about 1400 to about 1700 rpm two-step process and an 8-times concentrated solution of the PNCs and ligand molecules, this film is significantly thicker at about 100 nm. Afterward, a second electron beam exposure again at a dose of 4 µC/cm² crosslinks the second perovskite film. The result is a pristine perovskite film protected on both sides by a crosslink network lying on one side thereof on the release layer. If this stack is bathed in acetone, the solvent erodes the PMMA. Once the PNC film is entirely undermined, it swims in the solvent and can be picked up and transferred to another substrate.

Further aspects of the invention are denoted hereinafter.

According to an aspect, a method of manufacturing a perovskite nanocrystal (PNC) film is disclosed, the method comprising:
- providing a substrate,
- applying perovskite nanocrystals (PNCs) to the substrate,
- applying and binding ligand molecules to the perovskite nanocrystals (PNCs),
- directly crosslinking the ligand molecules to form a perovskite nanocrystal (PNC) film substrate assembly, and
- separating the perovskite nanocrystal (PNC) film substrate assembly from the substrate to obtain the perovskite nanocrystal (PNC) film.

Optionally, applying perovskite nanocrystals (PNCs) to the substrate, and/or applying and binding ligand molecules to the perovskite nanocrystals (PNCs) includes spin-coating.

Optionally, each of the ligand molecules has at least one first functional group adapted to bind to the perovskite nanocrystals (PNC) and optionally at least one second functional group adapted to directly crosslink with at least one functional group of another ligand molecule.

Optionally, the direct crosslinking the ligand molecules comprises one or more of radiation induced polymerization, such as electron radiation induced polymerization, X-ray radiation induced polymerization, UV light radiation induced polymerization or thermal radiation induced polymerization, chemically induced polymerization, and ligand bonding, preferably wherein the direct crosslinking the ligand molecules includes applying a catalyst.

Optionally, the direct crosslinking of the ligand molecules comprises radiation induced polymerization, wherein the substrate is at least partially permissive to the radiation, and the direct crosslinking of the ligand molecules includes transmitting the radiation through the substrate.

Optionally, the substrate includes a release layer adapted to separate the substrate from the perovskite nanocrystal (PNC) film, optionally wherein the release layer is made of PMMA.

Optionally, further comprising, after directly crosslinking the ligand molecules and/or after separating the perovskite nanocrystal (PNC) film from the substrate,
applying perovskite nanocrystals (PNCs) to the perovskite nanocrystal (PNC) film,
applying and binding ligand molecules to the perovskite nanocrystals (PNCs),
directly crosslinking the ligand molecules to obtain the perovskite nanocrystal (PNC) film with higher film thickness.

Optionally, the perovskite nanocrystals (PNCs) comprise APbX₃ perovskite nanocrystals, wherein A is selected from the group consisting of methylammonium, cesium, formamidinium, and X is selected from F, Cl, Br, I, preferably X is selected from Br and I; and/or the ligand molecules comprise styrene and 2-vinylpyridine suitable for the synthesis polystyrene-b-poly(2-vinylpyridine) , wherein b is a bond or an optional copolymer, such as a molecule with a CC double bond, preferably a terminal CC double bond.

Optionally, the perovskite nanocrystals (PNCs) comprise CsPbBr₃ perovskite nanocrystals, and/or the ligand molecules comprise oleic acid and oleylamine.

Optionally, applying perovskite nanocrystals (PNCs) to the substrate and applying and binding ligand molecules to the perovskite nanocrystals (PNCs) are carried out simultaneously.

Optionally, applying and binding ligand molecules to the perovskite nanocrystals (PNCs) includes mixing the perovskite nanocrystals (PNCs) with an alkyl carboxylic acid, an alkyl amine, and/or an alkyl alcohol, wherein at least one of the alkyl carboxylic acid, alkyl amine, and alkyl alcohol is unsaturated, to obtain ligand-mixed perovskite nanocrystals (PNCs).

Optionally, directly crosslinking the ligand molecules to form a perovskite nanocrystal (PNC) film substrate assembly includes subjecting the ligand-mixed perovskite nanocrystals (PNCs) to an electron beam, preferably a collimated electron beam, to form the perovskite nanocrystal (PNC) film substrate assembly.

Optionally, the perovskite nanocrystals (PNCs) are in form of nanorods and/or nanoplatelets.

Optionally, the perovskite nanocrystals (PNCs) comprise ABClₓBr_{y}I_{z} with A = Rb or Cs, B = Pb or Sn, 0 ≤ x ≤ 3, 0 ≤ y ≤ 3, and 0 ≤ z ≤ 3 with the proviso that x + y + z = 3.

Optionally, the alkyl carboxylic acid, the alkyl amine and alkyl alcohol comprise independently from each other 12 to 22 C-atoms.

Optionally, a volume ratio of the alkyl amine and/or alkyl alcohol to the unsaturated alkyl carboxylic acid is from about 1:2 to about 2:1.

Optionally, the perovskite nanocrystal (PNC) film substrate assembly is resistant to washing with polar solvents and apolar solvents, wherein the polar solvents include solvents with a polarity that is lower than the polarity of water and the apolar solvents include solvents with a polarity that is higher than the polarity of n-hexane.

Optionally, subjecting the ligand-mixed perovskite nanocrystals (PNCs) to an electron beam, preferably a collimated electron beam, comprises exposing the ligand-mixed perovskite nanocrystals (PNCs) to a dose of about 5 × 10² µC/cm² to about 2 × 10⁴ µC/cm².

Optionally, further comprising providing additional perovskite nanocrystals (PNCs) on the perovskite nanocrystal (PNC) film substrate assembly.

Optionally, providing additional perovskite nanocrystals (PNCs) comprises depositing the perovskite nanocrystals (PNCs) on a substrate, particularly a silicon substrate.

Optionally, depositing the perovskite nanocrystals (PNCs) includes spin-coating or dropcasting.

Optionally, the perovskite nanocrystals (PNCs) are deposited with a thickness of about 10 nm to about 300 nm, more preferably wherein the thickness is measured according to the description.

Optionally, separating the perovskite nanocrystal (PNC) film substrate assembly from the substrate to obtain the perovskite nanocrystal (PNC) film includes stripping off the perovskite nanocrystal (PNC) film substrate assembly from the substrate.

According to an aspect, a perovskite nanocrystal (PNC) film is disclosed, wherein the perovskite nanocrystal (PNC) film obtainable by the method (100) of manufacturing a perovskite nanocrystal (PNC) film.

According to an aspect, a perovskite nanocrystal (PNC) film is disclosed, the perovskite nanocrystal (PNC) film comprising:
perovskite nanocrystals (PNCs), and
ligand molecules binding the perovskite nanocrystals (PNCs),
wherein the ligand molecules are directly crosslinked, optionally further comprising a substrate supporting the perovskite nanocrystal (PNC) film.

Optionally, further comprising at least 50 wt.%, optionally at least 75 wt.%, perovskite nanocrystals (PNCs).

Optionally, the perovskite nanocrystals (PNCs) are monodisperse perovskite nanocrystals (PNCs).

Optionally, the film is a thin film, optionally of a thickness of about one to five, such as two, nanocrystals (PNCs).

According to an aspect, a direct-gap semiconductor is disclosed, the direct-gap semiconductor comprising the perovskite nanocrystal (PNC) film.

According to an aspect, a light-emitting diode is disclosed, the light-emitting diode comprising the perovskite nanocrystal (PNC) film or the direct-gap semiconductor.

According to an aspect, a solar cell, such as a tandem solar cell, is disclosed, the solar cell, such as a tandem solar cell, comprising the perovskite nanocrystal (PNC) film or the direct-gap semiconductor.

Further details and advantages will now be explained in more detail with reference to the following examples and optional embodiments with reference to the figures.
Figure 1 shows a schematic view of a PNC film according to an embodiment;
Figure 2 shows a schematic view of a thickened PNC film according to an embodiment;
Figure 3 shows a schematic view a PNC film according to an embodiment;
Figure 4 schematically shows a method for forming a PNC film; and
Figure 5A and 5B schematically show a direct-gap semiconductor, a light-emitting diode, and a solar cell including the present PNC film.

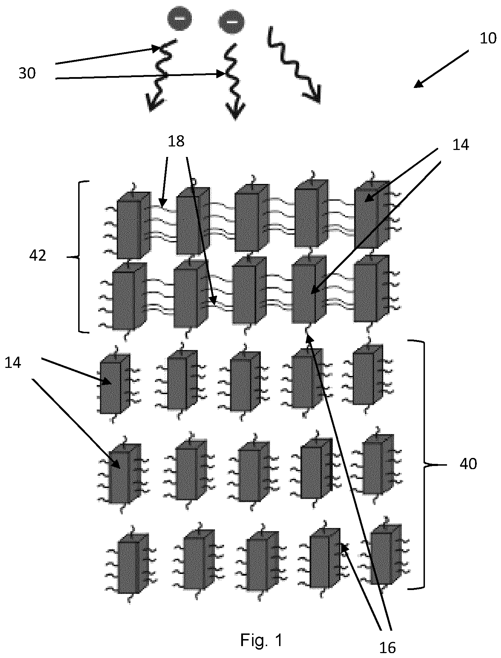

With first reference to Figure 1, a schematic view a perovskite nanocrystal (PNC) film 10 according to an embodiment of the invention is shown.

A plurality of perovskite nanocrystals (PNCs) 14 is arranged adjacent to each other, forming a first network 40 of individual PNCs 14. Each of the PNCs 14 is provided with ligand molecules 16 attached via a first functional group to a metal ion of a PNC 14, the first functional group forming in the present case an ionic bond to the positively charged metal ion. Each of the ligand molecules 16 is further provided with a second functional group capable of being crosslinked to a second functional group of another ligand molecule 16 to form crosslinked ligand molecules 18 upon contact with a catalyst, which in the present exemplary embodiment is UV radiation 30. Alternatively, instead of the UV radiation 30, other means for crosslinking can be used, including for instance electrons from an electron beam, preferably from a collimated electron, or chemical crosslinking agents.

It can be seen that the UV radiation 30 has a limited penetration depth into the PNCs 14 as the UV radiation 30 is blocked by the PNCs 14. Thereby, a second network 42 of ligand molecules 16 located at a surface of the PNC film 10 is formed, wherein the PNCs 14 are interconnected/ crosslinked with crosslinked ligand molecules 18. PNCs 14 and crosslinked ligand molecules 18 of the second network 42 form a coordination polymer like structure. In deeper areas from the PNCs 14 at which the UV radiation 30 has not sufficient intensity for crosslinking the ligand molecules 16, such that the PNCs 14 and ligand molecules 16 form the first network 40, in which the second functional groups of the ligand molecules 16 are not reacted and do not form crosslinked ligand molecules 18.

In deeper regions of the PNCs 13 where the UV radiation 30 does not have sufficient intensity to crosslink the ligand molecules 16. the PNCs 14 and ligand molecules 16 form the first network 40 in which the second functional groups of the ligand molecules 16 are essentially not reacted and do not form crosslinked ligand molecules 18.

It will be appreciated that Figure 1 is for illustrative purposes only and that the second network 42 can comprise more than two layers of PNCs 14, such as three, four, five, six layers or even more than six layers of PNCs 14. In addition or alternatively, the transition from the second network 42 to the first network 40 can be fluid, such that in one or more layers between the second and first networks 42, 40, the crosslinking is incomplete and only some of the ligand molecules 16 are crosslinked and others are not.

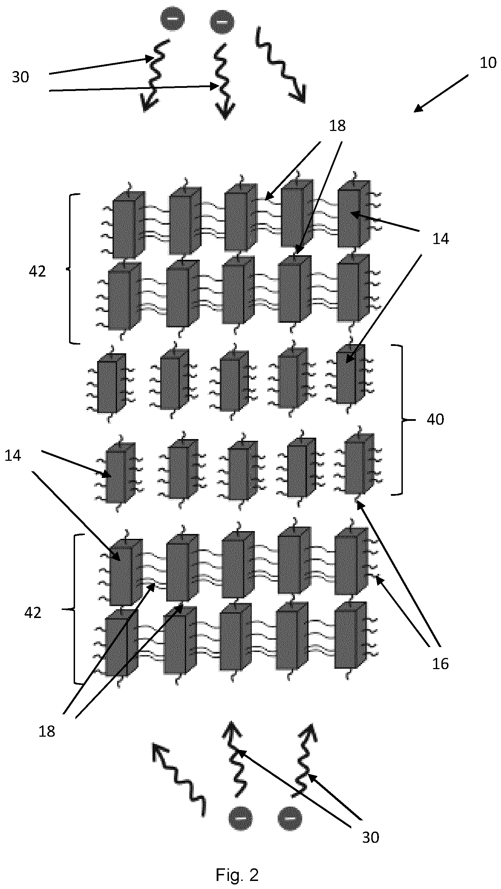

With further reference to Figure 2, a schematic view a thickened PNC film 10 is shown. PNCs 14 located on the other side of the PNC film 10 are accessible to UV radiation 30 such that the PNCs 16 are crosslinked via ligand molecules 16 to form crosslinked ligand molecules 18.

This may be achieved either by releasing/stripping the PNC film 10 of Figure 1 from a substrate (not shown), with the substrate and second network 42 sandwiching the first network 40, followed by adding additional layers of PNCs 14 and ligand molecules 16 to the first network 40 and subjecting the ligand molecules 16 to crosslinking. Alternatively, the first network 40 may be crosslinked directly without the need to add additional layers of PNCs 14 and ligand molecules 16. In a still further alternative, where radiation is used for crosslinking, the radiation may even be applied through a suitable substrate provided that the substrate is at least partially permissive to the radiation. This avoids the need to release/strip the PNC film 10 of Figure 1 from the substrate.

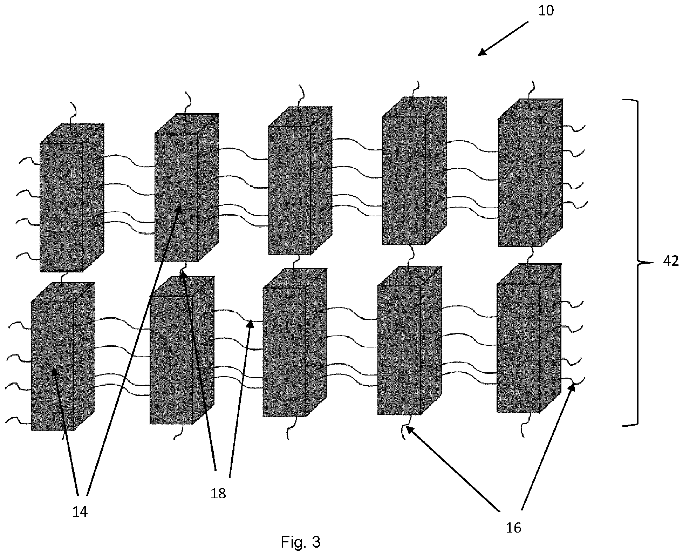

With further reference to Figure 3, a schematic view of a film 10 is shown. It can be seen that the PNCs 14 are all crosslinked to their respective neighboring PNCs by crosslinked ligand molecules 18. Crosslinking of all PNCs 14 of the film 10 can be performed by establishing a second layer 42, and repeated application of first layers 40 that directly followed from their conversion into second layers 42. The entire PNC film 10 thus includes the second network 42 forming a three-dimensional network which stabilizes the PNC film 10, particularly protecting the PNC film 10 from mechanical stress thereby greatly facilitates handling of the PNC film 10, such as the transfer of the film 10.

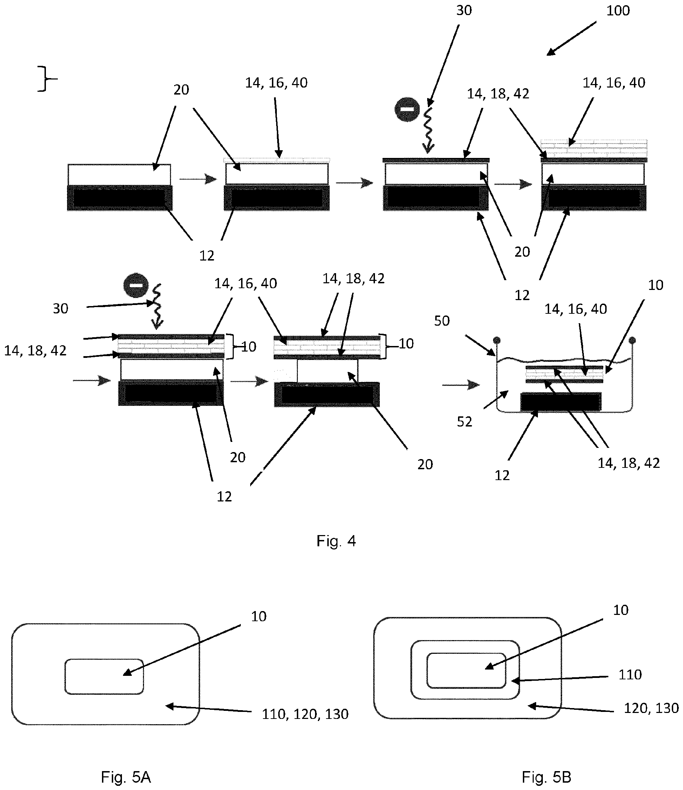

With reference to Figure 4, a method 100 of manufacturing a perovskite nanocrystal (PNC) film 10 is schematically shown.

Starting from a substrate 12, e.g. made of a radiation permissible material, such as a suitable silicon substrate, the substrate 12 is provided with a release layer 20 that can be made e.g. from PMMA (polymethylmethacrylate).

The release layer 20 is provided, e.g. in course of a double spincoat and crosslink procedure, with a first network 40 of PNCs 14 and ligand molecules 16 forming e.g. one, two, or three layers of PNCs 14 on the release layer 20. The ligand molecules 16 are already attached to the individual PNCs 14 with their first functional group by ionic binding.

By applying UV radiation 30 to the first network 40 at a side thereof that is turned away from the release layer 20, the second functional groups of the ligand molecules 16 react with each other forming crosslinked ligand molecules 18 converting the first network 40 to the second network 42. The second network 42 is provided with additional layers of PNCs 14 and ligand molecules 16 to a predetermined thickness forming another first network 40, UV radiation 30 is applied to the first network 49 such that one or more outer layers of PNCs 14 and ligand molecules 16 of the first network 40 are subjected to crosslinking by reacting the second functional groups of the ligand molecules to form crosslinked ligand molecules 18 of another second network 42. Thereby a PNC film 10 is obtained, in which a first network 42 of non-interconnected PNCs 14 is sandwiched by two second networks 42 of PNCs 14 with crosslinked ligand molecules 18, one of the second networks 14 being provided on the release layer 20 of the substrate 12.

The free-standing PNC film 10 is obtainable by immersing the substrate 12, release layer 20, and PNC film 10 to a solvent 52 in a vessel 50. The solvent 52 is in case of the release layer 20 made of PMMA an organic solvent, particularly acetone, that dissolves the PMMA thereby releasing the PNC film 10 from the substrate 12 for obtaining the free-standing PNC film 10. With further reference to EP 24 154 048, it can be seen from Figure 4b that the free-standing PNC film 10 or the crosslinked perovskite foil has photoluminescence (PL) despite swimming in acetone as solvent 52 for 1.5 hours and still emitting blue PL suggesting that the free-standing PNC film 10 is well suited for preparing a solar cell, particularly a tandem solar cell. Photoluminescence (PL) measurement has been performed with a FluoroMax Plus by HORIBA Scientific that was used according to the manufacturer's instructions.

Specifically, in the present case UV-C light is used as the UV radiation 30 for crosslinking of the PNCs 14.

In contrast, when the above method was used to prepare a PNC film 10 by omitting crosslinking of the ligand molecules 18, i.e., by omitting applying the UV radiation 30, merely the PNC substrate assembly, i.e. a PNC film immobilized on the substrate 12 via the release layer 20, exhibited photoluminescence. However, when this PNC substrate assembly was immersed in acetone, the photoluminescence disappeared in less than 5 seconds, indicating that the PNC film was destroyed and no free-standing PNC film 10 was obtained.

In another example, the above method for preparing a free-standing PNC film 10 with and without crosslinking of the ligand molecules 18 by application of UV radiation 30 was repeated. The only difference was that the release layer 20 was prepared from PEG 2000 (Sigma Aldrich) and the immobilized PNC film 10 was immersed in a water bath to dissolve the release layer 20. In this case, the film 10 still shows photoluminescence after more than 1.5 hours in the water bath, whereas the photoluminescence of the uncrosslinked perovskite film 10 subsequently disappeared, within a couple of seconds, when the PNC substrate assembly was transferred to the water bath. It can be even assumed that the Brownian motion alone was sufficient to destroy/"dissolve" the (not-crosslinked) PNC film released from the PNC substrate assembly.

### Setup-description:

For the procedure, the sample to be exposed needs to be placed an inert gas, such as nitrogen, containing chamber to exclude the presence of oxygen during the irradiation process. Ideally, a constant flow of inert gas is supplied to the chamber to remove any gaseous degradation products that may emerge during the irradiation process.

A UV-C light source with a spectral power maximum at 254 nm is employed. The light source is either contained inside the inert-gas chamber or on the outside. For use of an externally placed light source it is crucial to employ the correct window material to ensure emissivity at 254 nm (e.g. Quartz glass). The UV-C light source is preferably a collimated UV-C light source in order to obtain a more uniform crosslinking of the PNC film 10, generally resulting in a film 10 with a higher (mechanical) stability.

For the in-house employed setup a custom-made aluminum chamber with two openings for inert gas in- & outflow was employed. A quartz glass viewing window (VPKF-40Q-E-Z Viewport, Vacom) was employed and mounted onto the chamber with a KF40-vacuum clamp. The light source employed is a Phillips TUV PL-L 35 W 4P 2G11 mercury lamp. Substrate to lamp distance is at 3 cm.

### Crosslinking of the ligand molecules 16 of the PNCs 14 for obtaining a second network 42:

The samples employed for crosslinking are comprised of polystyrene-poly(2-vinylpyridine) and APbX₃ perovskite nanocrystals (A = methylammonium, cesium, formamidinium, and X = iodine) dispersed in toluene.

Deposition of the polymer nanocrystal dispersion onto the release layer 20 of substrates 12 can be done via dropcasting or spin-coating. In the present case, a dropcast was used. Substrates employed for the procedure are cleaned prior to sample deposition by a three-step ultrasonication procedure (37 kHz, 100%, 5 min) in 1) D1 water, 2) iso-propanol, 3) acetone. The substrates are subsequently dried with a nitrogen gun and plasma cleaned (O₂, 10 sccm, 10 min). Sample deposition takes place immediately after plasma cleaning.

For dropcasting, a varying amount of dispersion (50-150 µL) is deposited on the substrate 12 (10×10 mm) and left to dry for at least two hours. For spin coating (of 10×10 mm substrates 12), 70 µL of dispersion are statically spin coated in a two-step procedure. I.) 800 rpm, 1000 rpm/s accel., 20 s II.) 6000 rpm, 2500 rpm/s accel., 30 s. The samples are placed inside the aluminum chamber and sealed with the quartz-window and vacuum-clamp. A constant nitrogen flow of at least 1 L/min is applied for 5 min prior to irradiation. The constant nitrogen flow is maintained throughout the entire procedure. Finally, the sample is irradiated for varying amounts of time. Time of irradiation is dependent on sample composition and lamp power. Further information is available from EP 24 154 048.

The method 100 may be also performed according to said EP 24 154 048, the contents of which are incorporated by way of reference in their entirety showing in Figure 4 a similar method.

Figure 5A schematically shows a direct-gap semiconductor 110, a light-emitting diode 120, a sensor, or a solar cell 130, such as a tandem solar cell, respectively comprising the present perovskite nanocrystal (PNC) film 10.

Figure 5B shows a direct-gap semiconductor 110 comprising the present perovskite nanocrystal (PNC) film 10, the direct-gap semiconductor 110 being included in a light-emitting diode 120, a sensor or a solar cell 130, such as a tandem solar cell.

### Reference signs

- 10: PNC film
- 12: substrate
- 14: perovskite nanocrystals (PNCs)
- 16: ligand molecules
- 18: crosslinked ligand molecules
- 20: release layer
- 30: UV radiation
- 40: first network
- 42: second network
- 50: vessel
- 52: solvent
- 100: method of manufacturing a perovskite nanocrystal (PNC) film
- 110: direct-gap semiconductor
- 120: light-emitting diode
- 130: solar cell

## Claims

1. A method (100) of manufacturing a perovskite nanocrystal (PNC) film (10), comprising:
- providing a substrate (12),
- applying perovskite nanocrystals (PNCs) (14) to the substrate (12),
- applying and binding ligand molecules (16) to the perovskite nanocrystals (PNCs) (14),
- directly crosslinking the ligand molecules (16) to form a perovskite nanocrystal (PNC) film substrate assembly, and
- separating the perovskite nanocrystal (PNC) film substrate assembly from the substrate to obtain the perovskite nanocrystal (PNC) film (10).

2. The method (100) of claims 1, wherein applying perovskite nanocrystals (PNCs) (14) to the substrate (12), and/or applying and binding ligand molecules (16) to the perovskite nanocrystals (PNCs) (14) includes spin-coating.

3. The method (100) of any of claims 1-2, wherein each of the ligand molecules (16) has at least one first functional group adapted to bind to the perovskite nanocrystals (PNC) (10) and optionally at least one second functional group adapted to directly crosslink with at least one functional group of another ligand molecule (16).

4. The method (100) of any of claims 1-3, wherein the direct crosslinking the ligand molecules (16) comprises one or more of radiation induced polymerization, such as electron radiation induced polymerization, X-ray radiation induced polymerization, UV light radiation induced polymerization or thermal radiation induced polymerization, chemically induced polymerization, and ligand bonding, preferably wherein the direct crosslinking the ligand molecules (16) includes applying a catalyst.

5. The method (100) of any of claims 1-4, wherein the direct crosslinking of the ligand molecules (16) comprises radiation induced polymerization, wherein the substrate (12) is at least partially permissive to the radiation, and the direct crosslinking of the ligand molecules (16) includes transmitting the radiation through the substrate (12).

6. The method (100) of any of claims 1-5, wherein the substrate (12) includes a release layer (20) adapted to separate the substrate from the perovskite nanocrystal (PNC) film, optionally wherein the release layer is made of PMMA.

7. The method (100) of any of claims 1-6, further comprising, after directly crosslinking the ligand molecules (16) and/or after separating the perovskite nanocrystal (PNC) film (10) from the substrate,
applying perovskite nanocrystals (PNCs) (14) to the perovskite nanocrystal (PNC) film (10),
applying and binding ligand molecules (16) to the perovskite nanocrystals (PNCs) (14),
directly crosslinking the ligand molecules (16) to obtain the perovskite nanocrystal (PNC) film (10) with higher film thickness.

8. The method (100) of any of claims 1-7, wherein applying perovskite nanocrystals (PNCs) (14) to the substrate (12) and applying and binding ligand molecules (16) to the perovskite nanocrystals (PNCs) (14) are carried out simultaneously.

9. A perovskite nanocrystal (PNC) film (10) obtainable by the method (100) of any of the claims 1-8.

10. A perovskite nanocrystal (PNC) film (10), comprising:
perovskite nanocrystals (PNCs) (14), and
ligand molecules binding the perovskite nanocrystals (PNCs) (16),
wherein the ligand molecules (16) are directly crosslinked, optionally further comprising a substrate (12) supporting the perovskite nanocrystal (PNC) film (10).

11. The film (10) of claim 10, comprising at least 50 wt.%, optionally at least 75 wt.%, perovskite nanocrystals (PNCs) (14).

12. The film (10) of any of claims 10-11, wherein the perovskite nanocrystals (PNCs) (14) are monodisperse perovskite nanocrystals (PNCs).

13. The film (10) of any of claims 10-12, wherein the film (10) is a thin film, optionally of a thickness of about one to five, such as two, nanocrystals (PNCs) (14).

14. A direct-gap semiconductor (110) comprising the perovskite nanocrystal (PNC) film (10) of any of claims 9-13.

15. A light-emitting diode (120) comprising the perovskite nanocrystal (PNC) film (10) of any of claims 9-13 or the direct-gap semiconductor (110) of claim 14, a sensor comprising the perovskite nanocrystal (PNC) film (10) of any of claims 9-13 or the direct-gap semiconductor (110) of claim 14, or a solar cell (130) comprising the perovskite nanocrystal (PNC) film (10) of any of claims 9-13 or the direct-gap semiconductor (110) of claim 14.
